Europäisches Patentamt

European Patent Office

Office européen des brevets

(19)

(11) **EP 0 782 265 B1**

(12) **FASCICULE DE BREVET EUROPEEN**

(45) Date de publication et mention
de la délivrance du brevet:
**04.06.2003 Bulletin 2003/23**

(51) Int Cl.$^7$: **H03K 17/082**, H02P 1/18

(21) Numéro de dépôt: **96402915.1**

(22) Date de dépôt: **27.12.1996**

(54) **Procédé et dispositif pour la protection d'un élément à impédance réglable commandant l'alimentation d'un moteur électrique, notamment de véhicule automobile**

Verfahren und Vorrichtung zum Schutz eines einstellbaren Impedanzelements zur Steuerung der Stromversorgung eines Elektromotors, insbesondere eines Kraftfahrzeugs

Method and device for protecting an adjustable impedance element controlling the supply of an electric motor, particularly of a motor vehicle

(84) Etats contractants désignés:
**DE ES GB IT**

(30) Priorité: **29.12.1995 FR 9515730**

(43) Date de publication de la demande:
**02.07.1997 Bulletin 1997/27**

(73) Titulaire: **VALEO ELECTRONIQUE**
**94042 Creteil Cédex (FR)**

(72) Inventeur: **Permuy Alfred**
**92500 Rueil-Malmaison (FR)**

(74) Mandataire: **Schrimpf, Robert**
**Cabinet Regimbeau**
**20, rue de Chazelles**
**75847 Paris cedex 17 (FR)**

(56) Documents cités:
**EP-A- 0 327 881**      **DE-A- 4 115 295**

## Description

La présente invention est relative à un procédé et à un dispositif pour la protection d'un élément à impédance réglable, tel qu'un transistor commandant l'alimentation d'un moteur électrique, par limitation du courant qui traverse ledit transistor.

L'invention trouve avantageusement application dans le domaine des véhicules automobiles, notamment pour la protection de la commande d'un moteur électrique de chauffage, ventilation ou climatisation d'habitacle de véhicule automobile ou pour celle d'un moteur électrique de ventilateur de refroidissement d'un moteur à combustion interne de véhicule automobile.

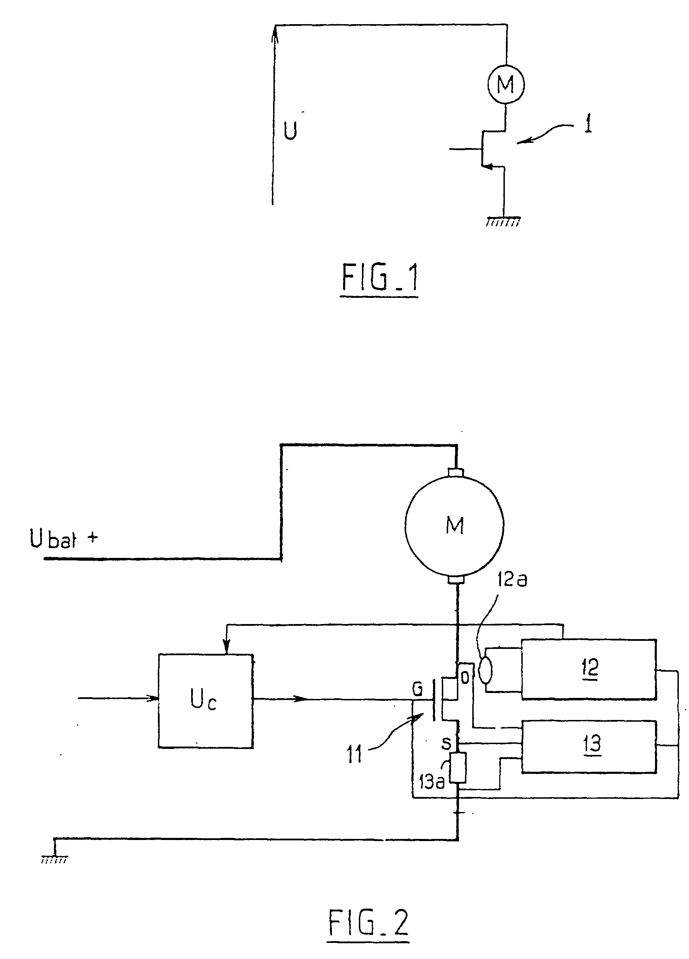

On a représenté schématiquement sur la figure 1 un moteur électrique M alimenté par une source de tension continue U, telle que la batterie d'un véhicule automobile, ainsi qu'un transistor 1 de type MOSFET qui est connecté entre ledit moteur M et la masse et qui commande l'alimentation de ce moteur M.

Il est connu de protéger un tel transistor de commande contre les élévations de courant du circuit.

Généralement, il est prévu à cet effet une électronique complémentaire qui vise à limiter le courant à une valeur seuil donnée.

Cette valeur seuil de courant est la même quelle que soit la tension aux bornes du moteur.

Une telle protection s'avère toutefois souvent insatisfaisante.

Notamment, au démarrage, le rotor du moteur est bloqué du fait de son inertie importante, de sorte que le moteur se comporte comme une charge résistive. La fermeture du transistor génère par conséquent un appel de courant important qui est source d'échauffements qui peut détériorer le transistor.

Par exemple, dans le cas d'une alimentation par la tension de la batterie (13 Volts), et dans l'hypothèse où le moteur M se comporte comme une charge résistive d'une résistance R de 0,1 Ohms, la puissance que doit supporter le transistor 1 au démarrage est alors de 300 W, c'est-à-dire deux fois la puissance maximale que peut normalement supporter un transistor MOSFET par exemple.

Egalement, en fonctionnement nominal, c'est-à-dire lorsque le moteur tourne à la vitesse nominale, le rotor du moteur peut se bloquer du fait de la présence d'un corps étranger dans le mécanisme entraîné, ce qui se traduit par une élévation rapide du courant.

Enfin, un disfonctionnement classique est constitué par un court-circuit dans le moteur qui provoque également un appel important de courant.

Toutes les configurations décrites ci-dessus se traduisent par des valeurs importantes du courant dans le transistor qui commande le moteur. Lorsque la tension entre le drain et la source du transistor est importante, ce courant entraîne une surpuissance qui peut endommager le transistor.

Or cette tension dépend de la tension aux bornes du moteur.

Un but de l'invention est donc de proposer une limitation de courant qui permette de protéger efficacement contre les surpuissances, dans toutes les situations de fonctionnement du moteur, un élément de commande de l'alimentation à impédance réglable, tel qu'un transistor.

On connaît déjà par DE-41 15 295 une commande d'alimentation d'un moteur électrique selon laquelle le courant absorbé par le moteur est limité par un seuil d'intensité qui varie en cours de fonctionnenent en étant en début de démarrage inférieur au seuil d'intensité autorisé en régime de fonctionnement nominal.

Selon la technique décrite dans ce document, un transistor qui commande l'alimentation d'un moteur électrique est actionné selon une séquence d'ouvertures et de fermetures qui impose audit moteur une tension moyenne proportionnelle à une tension de commande $U_{st}$.

Un seuil pour la régulation de l'intensité moyenne absorbée par le moteur est déterminé en fonction de cette tension de commande, ce seuil étant croissant avec ladite tension.

Lorsque l'intensité atteint sa valeur seuil, le rapport cyclique de la séquence d'ouvertures et de fermetures du transistor est commandé pour faire baisser ladite intensité en dessous de ladite valeur seuil. Toutefois, la valeur seuil précitée reste constante puisque la tension de commande $U_{st}$ est a priori inchangée. Par conséquent, l'intensité reste au voisinage de ladite valeur seuil.

De ce fait, si la tension aux bornes du moteur devient très faible, la tension aux bornes du transistor MOSFET peut être telle que la surpuissance peut l'endommager. De plus, avec le montage de commande de DE-41 15 295, il est nécessaire de prévoir des moyens complémentaires pour la détection de court-circuit du moteur et pour la coupure instantanée de son alimentation, ainsi que des moyens de temporisation et des moyens pour redémarrer progressivement le moteur après une durée de coupure déterminée.

L'invention propose quant à elle - pour la protection d'un élément à impédance réglable (et non d'un interrupteur tout ou rien comme dans DE-41 15 265) - une commande qui permet dès qu'une élevation de courant est constatée, de faire redescendre le courant jusqu'à une valeur faible. L'élément de commande est ainsi efficacement protégé, et ce au moyen d'un montage d'une grande simplicité.

La solution selon l'invention consiste en ce que le seuil d'intensité auquel le courant est limité est une fonction croissante de la tension aux bornes du moteur.

On sait en effet que la tension $U_M$ aux bornes du moteur vérifie :

$$U_M = K\Omega + RI$$

où Ω est la vitesse de rotation du moteur, I l'intensité du courant absorbé par celui-ci, R sa résistance et K un paramètre du moteur.

Avec la solution proposée par l'invention, lorsque l'intensité dépasse sa valeur seuil, la commande fait baisser la valeur de ladite intensité et par conséquent la valeur de $U_M$ et de l'intensité seuil.

Il en résulte dans le cas du blocage du moteur une diminution rapide de l'intensité de courant du moteur jusqu'à un point d'équilibre où le moteur ne tourne plus. Dans le cas d'un court-circuit, l'intensité du courant prend la valeur seuil autorisée pour une tension moteur nulle.

Dans l'un et l'autre cas, l'intensité de courant ainsi imposée est faible par rapport à l'intensité en fonctionnement nominal.

Avantageusement, les caractéristiques du courant seuil en fonction de la tension du moteur sont choisies de façon que l'intensité seuil autorisée pour une tension nulle entre les extrémités du moteur soit suffisante pour permettre le démarrage dudit moteur.

Ainsi, notamment, lorsque l'intensité et la tension du moteur sont ramenées au point d'équilibre du moteur par un blocage de celui-ci, le moteur peut repartir immédiatement dès que le couple de blocage disparaît.

D'autres caractéristiques et avantages de l'invention ressortiront encore de la description qui suit. Cette description est purement illustrative et non limitative. Elle doit être lue en regard des dessins annexés sur lesquels :

- la figure 1 représente schématiquement un circuit pour l'alimentation d'un moteur électrique par une tension continue ;
- la figure 2 représente schématiquement un circuit d'alimentation semblable à celui de la figure 1, qui comporte en outre un dispositif de limitation conforme à un mode de réalisation possible de l'invention ;
- la figure 3 est une courbe de limitation de courant conforme à l'invention ;
- la figure 4 est un schéma illustrant un mode de réalisation possible pour un circuit analogique de limitation de courant conforme à l'invention.

Le circuit d'alimentation illustré sur la figure 2 comporte un moteur électrique M alimenté par une source de tension continue U, ainsi qu'un transistor de type MOSFET 11 qui constitue un élément à impédance réglable qui commande l'alimentation de ce moteur M.

Ce moteur M est par exemple un moteur de chauffage, ventilation ou climatisation d'habitacle de véhicule automobile.

La source S du transistor 11 est reliée à la masse, tandis que son drain D est relié à l'une des bornes du moteur M.

La grille G du transistor 11 est commandée en tension par une unité de commande $U_c$ pour commander, en fonctionnement normal, l'intensité du courant dans le moteur par réglage de l'impédance dudit transistor.

Dans le cas où le moteur M est un moteur de ventilation, l'unité de commande $U_c$ comporte par exemple le microprocesseur de gestion de la climatisation du véhicule.

En variante, l'unité de commande peut bien entendu comporter un circuit ASIC.

Cette unité de commande $U_c$ reçoit des organes de commande à l'intérieur du véhicule une information relative à la commande du moteur M.

Dans le cas d'une commande en tension, l'unité de commande $U_c$ comporte des moyens non représentés pour imposer la tension $U_M$ aux bornes du moteur M en fonction de la vitesse de rotation désirée du moteur.

Dans le cas d'une commande en courant, l'unité de commande $U_c$ applique à la grille G du transistor 11 une tension qui définit le courant I circulant dans le transistor 11 et donc dans le moteur M.

L'invention s'applique indistinctement à l'une ou l'autre de ces commandes.

Le circuit comporte en outre une unité 12 pour la limitation de la température du transistor 11, ainsi qu'une unité 13 de limitation de courant.

L'unité 12 ne sera pas ici particulièrement décrite. Elle reçoit d'une sonde thermique 12a située à proximité du transistor 11 une information sur la température de celui-ci et modifie la tension de grille appliquée par l'unité de commande $U_c$ audit transistor 11 en fonction de cette information de température.

L'unité 13 est reliée à des moyens 13a pour mesurer l'intensité du courant qui traverse ledit transistor 11. Ces moyens 13a sont constitués par une résistance shunt 13a montée en série avec le moteur M et le transistor 11. La tension entre les extrémités de ladite résistante 13a, qui est proportionnelle au courant I qui traverse le transistor 11, est injectée en entrée de l'unité de limitation de courant 13.

Des moyens pour mesurer la tension $U_M$ sont également prévus. Par exemple, la tension entre le moteur M et le drain du transistor 11 est injectée en entrée de l'unité 13.

Cette unité 13 comporte des moyens pour comparer ce courant à des valeurs seuils fonction de la tension $U_M$ du moteur M et pour modifier la tension appliquée à la grille G du transistor 11 par l'unité de commande $U_c$ de façon à maintenir ledit courant en dessous desdites valeurs seuils.

Les valeurs d'intensités seuils sont croissantes en fonction de la tension $U_M$. En particulier, l'intensité maximale $I_0$ admise au démarrage est très inférieure à l'intensité maximale $I_{Nmax}$ en régime de fonctionnement nominal, de sorte que la puissance que doit supporter le transistor 11 au démarrage est très faible.

L'intensité $I_0$ au démarrage est toutefois bien entendu suffisante pour permettre le démarrage du moteur. Elle est par exemple de l'ordre de 2,5 Ampères.

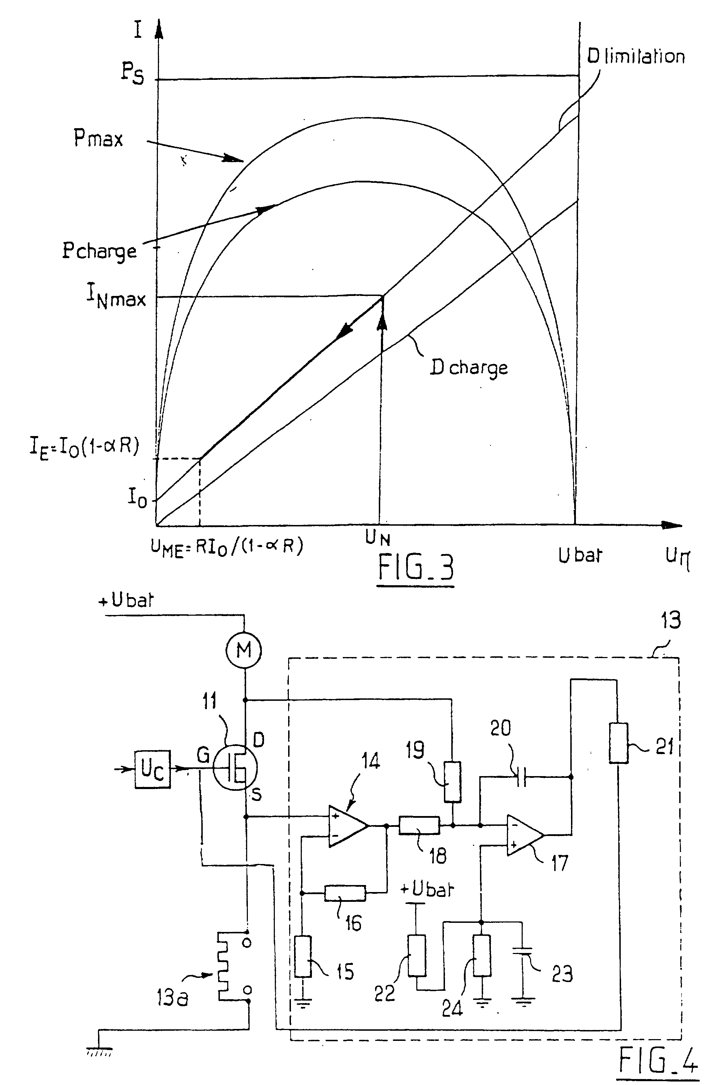

L'unité de limitation de courant 13 est par exemple un circuit analogique qui impose à l'intensité I du courant qui traverse le transistor 11 une valeur seuil qui, ainsi qu'on l'a illustré sur la figure 3, est une fonction linéaire de la tension $U_M$ du moteur M (droite $D_{limitation}$).

En fonctionnement nominal, la tension $U_M$ aux bornes du moteur varie entre 0 et $U_{bat}$, où $U_{bat}$ est la tension de batterie, en fonction de la vitesse désirée du moteur.

On se place en effet dans le cas d'une commande en tension du moteur.

Un exemple de mise en oeuvre de la limitation de courant est illustrée sur la figure 3 par les flèches qui y ont été portées.

On considère que le moteur tourne initialement à sa vitesse nominale, de telle sorte que la tension $U_M$ à ses bornes soit égale à une valeur $U_N$ déterminée entre 0 et $U_{bat}$. Le courant absorbé par le moteur M est alors d'une intensité comprise entre celle du courant imposé par la droite de charge ($D_{charge}$) pour cette tension $U_N$ et une valeur seuil $I_N$max.

Si le rotor du moteur M est freiné, la force électro-motrice développée par ledit moteur M chute, de sorte que le courant augmente.

Lorsque l'intensité du courant atteint la valeur seuil $I_N$max qui correspond à cette tension nominale $U_N$, c'est à dire lorsqu'elle atteint la droite $D_{limitation}$, l'unité 13 commande le transistor 11 de façon à réduire l'intensité du courant.

Il en résulte une diminution de la vitesse et donc de la tension $U_M$ du moteur M, et donc également une diminution de l'intensité seuil pour le courant.

Par conséquent, l'unité 13 va commander le transistor 11 de telle sorte que la tension $U_M$ et l'intensité I du courant du moteur M vont simultanément diminuer en se déplaçant sur la droite $D_{limitation}$ jusqu'à un point d'équilibre tel que :

$$I = \alpha\, U_M + I_0$$

et

$$U_M = RI,$$

où $\alpha$ est la pente de la droite $D_{limitation}$ et R la résistance du moteur au démarrage,

Ce point d'équilibre correspond donc à :

$$I_E = I_0/(1-\alpha R)$$

$$U_M = R\, I_0/(1-\alpha R)$$

Par conséquent, lorsque le moteur M est bloqué, l'unité 13 limite l'intensité de son courant à $I_0/(1-\alpha R)$, dont la valeur est très inférieure à la valeur $I_N$max qui peut être atteinte en régime nominal.

Par exemple, avec les valeurs déjà citées pour R et I et pour $\alpha$ de l'ordre de 6 A/V, l'intensité $I_E$ du courant rotor bloqué est d'environ 6 A, tandis que l'intensité Imax pour $U_M = U_{bat}$ est de l'ordre de 80 A.

Lorsque le couple de frein est relâché, la tension $U_M$ augmente à nouveau jusqu'à la tension de fonctionnement nominal UN.

Par ailleurs, on notera que la courbe de limitation de courant illustrée sur la figure 3 permet également de limiter l'intensité du courant à une valeur très inférieure à Imax, lorsque le moteur M est en court-circuit. La tension $U_M$ étant nulle, l'intensité du courant est en effet alors limitée à $I_0$.

On également représenté sur la figure 3 la puissance maximale Pmax que doit supporter le transistor 11 avec la limitation de courant linéaire illustrée sur cette figure. A titre indicatif, on a également porté sur cette figure 3 la puissance $P_{charge}$ que supporte le transistor 11 lors de la charge du moteur M en cas de fonctionnement normal.

Quelle que soit la valeur de la tension $U_M$ du moteur, la puissance Pmax est inférieure à la puissance seuil $P_s$ au dessus de laquelle le transistor 11 se détériore.

En situation de court-circuit, c'est-à-dire lorsque la tension aux bornes du moteur est nulle, la puissance Pmax est $U_{bat} \times I_0$, c'est-à-dire de l'ordre de 30 W.

Lorsque le moteur est en situation bloquée, son intensité est limitée à $I_E$ et la puissance qui traverse le transistor MOS est :

$$(U_{bat} - RI_E) \times I_E,$$

c'est-à-dire de l'ordre de 50 W.

Par conséquent, dans les deux cas, la puissance maximale Pmax que doit supporter le transistor 11 est très limitée.

On se réfère maintenant à la figure 4 sur laquelle on a représenté un exemple de circuit analogique 13 permettant de réaliser une limitation linéaire du type de celle qui vient d'être décrit.

Ce circuit comporte un amplificateur opérationnel 14 dont l'entrée non inverseuse est reliée à la source du transistor 11 et dont l'entrée inverseuse est reliée à la masse par l'intermédiaire d'une résistance 15 de 12 kOhms.

Une résistance 16 de 100 kOhms est montée en contre-réaction entre la sortie de l'amplificateur 14 et son entrée inverseuse.

La source S du transistor 11 est reliée à la masse à travers la résistance 13a formant shunt pour la mesure du courant I circulant dans le moteur.

Ainsi, l'amplificateur opérationnel 14 fonctionne en amplificateur de la tension aux bornes du shunt 13a

La sortie de l'amplificateur opérationnel 14 est reliée à l'entrée inverseuse d'un amplificateur opérationnel 17 par une résistance 18 de 27 kOhms.

Cette sortie inverseuse est en outre reliée par une résistance 19 de 270 kOhms au drain du transistor 11.

Un condensateur 20 de 47 nF est monté entre la sortie de l'amplificateur 17 et son entrée inverseuse.

Cette sortie de l'amplificateur 17 est en outre reliée par une résistance 21 de 220 kOhms à la grille du transistor 11.

La sortie non inverseuse de l'amplificateur opérationnel 17 reçoit en outre une tension de référence, qui lui est fournie par la tension de la batterie à laquelle elle est reliée par l'intermédiaire d'une résistance 22 de 240 kOhms. Cette entrée non inverseuse est en outre reliée à la masse par l'intermédiaire d'un condensateur 23 présentant une capacité de 22 nF, monté en parallèle avec une résistance 24 de 27 kOhms.

Les résistances 22 et 24 sont montées en pont diviseur pour générer une tension constante représentative de $I_0$. Le condensateur 23 est un condensateur de découplage.

Le sous-circuit qui comprend l'amplificateur 14 et les résistances 15 à 19 réalise également une combinaison linéaire entre la tension aux bornes de la résistance 13a formant shunt et la tension aux bornes du moteur.

La tension injectée sur l'entrée inverseuse de l'amplificateur 17 est représentative de la quantité I - $\alpha$ $U_M$ et est comparée par l'intermédiaire du sous-circuit constitué par l'amplificateur 17 et les éléments 20 à 24 à une tension représentative de $I_0$.

Lorsque I - $\alpha$ $U_M$ devient supérieur à $I_0$, c'est à dire lorsque l'intensité I devient supérieure à $I_0$ + $\alpha$ $U_M$, la tension en sortie de l'amplificateur 17 modifie la tension appliquée sur la grille G du transistor 11 de manière à réduire le courant I.

L'invention vient d'être décrite dans le cas d'une fonction de limitation de courant de type linéaire, qui est la plus simple à réaliser à l'aide d'un circuit analogique.

Bien entendu, d'autres types de fonctions de limitation sont envisageables.

Notamment, dans le cas où l'unité de limitation 13 est une unité de traitement numérique - ce qui est le cas par exemple si la fonction de limitation est gérée avec la fonction de commande de l'unité Uc , dans un même microprocesseur - la courbe de limitation de courant en fonction de la tension $U_M$ peut être de forme quelconque et est avantageusement choisie de façon à optimiser au mieux la dissipation de puissance dans le transistor 11.

## Revendications

1. Procédé de protection d'un élément à impédance réglable (11) commandant l'alimentation d'un moteur (M) électrique notamment de véhicule automobile, dans lequel on modifie la commande dudit élément à impédance réglable (11) lorsque l'intensité du courant qui le traverse est supérieure à un seuil donné, **caractérisé en ce que** ce seuil d'intensité est une fonction croissante de la tension ($U_M$) entre les extrémités du moteur (M).

2. Procédé selon la revendication 1, **caractérisé en ce que** l'intensité seuil autorisée pour une tension nulle entre les extrémités du moteur (M) est suffisante pour permettre le démarrage de celui-ci.

3. Procédé selon l'une des revendications précédentes, **caractérisé en ce que** l'intensité seuil est une fonction linéaire de la tension entre les extrémités du moteur (M).

4. Procédé selon l'une des revendications précédentes, **caractérisé en ce que** l'élément à impédance réglable (11) est un transistor de type MOSFET.

5. Dispositif de protection d'un élément à impédance réglable (11) commandant l'alimentation d'un moteur (M) électrique, notamment de véhicule automobile, comportant des moyens (13a) pour mesurer l'intensité du courant qui traverse ledit élément à impédance réglable (11) et une unité ($U_c$, 13) de limitation de courant qui est reliée auxdits moyens de mesure (13a) et qui commande ledit élément à impédance réglable (11) de façon à réduire ladite intensité est supérieure à un seuil donné, **caractérisé en ce que** ladite unité de limitation de courant comporte des moyens pour faire varier le seuil d'intensité de façon croissante avec la tension entre les extrémités du moteur (M).

6. Dispositif selon la revendication 5, **caractérisé en ce que** les moyens de mesure comportent une résistance shunt (13a) montée en série avec le moteur (M) et l'élément à impédance réglable (11), la tension entre les extrémités de ladite résistante (13a) étant injectée sur une entrée de l'unité de limitation de courant (13).

7. Dispositif selon l'une des revendications 5 et 6, **caractérisé en ce que** l'intensité seuil autorisée pour une tension nulle entre les extrémités du moteur (M) est suffisante pour permettre le démarrage de celui-ci.

8. Dispositif selon l'une des revendications 5 à 7, **caractérisé en ce que** l'unité (13) de limitation de courant est une unité analogique, l'intensité seuil étant une fonction linéaire de la tension aux bornes du moteur (M).

9. Dispositif selon l'une des revendication s 5 à 8, **caractérisé en ce que** l'unité (13) de limitation de courant est une unité de traitement numérique.

10. Dispositif selon l'une des revendications 5 à 9, **caractérisé en ce que** l'élément à impédance réglable (11) est un transistor de type MOSFET.

**Patentansprüche**

1. Verfahren zum Schutz eines einstellbaren Impedanzelements (11) zur Steuerung der Stromversorgung eines Elektromotors (M), insbesondere für ein Kraftfahrzeug, wobei die Steuerung des besagten einstellbaren Impedanzelements (11) verändert wird, wenn die Stromstärke des durch es hindurchfließenden Stroms größer als ein gegebener Schwellenwert ist, **dadurch gekennzeichnet, dass** dieser Stromstärkenschwellenwert eine steigende Funktion der Spannung ($U_M$) zwischen den Enden des Motors (M) ist.

2. Verfahren nach Anspruch 1, **dadurch gekennzeichnet, dass** die zulässige Schwellenstromstärke für eine Nullspannung zwischen den Enden des Motors (M) ausreichend ist, um das Anlassen dieses Motors zu ermöglichen.

3. Verfahren nach einem der vorangehenden Ansprüche, **dadurch gekennzeichnet, dass** die Schwellenstromstärke eine lineare Funktion der Spannung zwischen den Enden des Motors (M) ist.

4. Verfahren nach einem der vorangehenden Ansprüche, **dadurch gekennzeichnet, dass** das einstellbare Impedanzelement (11) ein MOSFET-Transistor ist.

5. Vorrichtung zum Schutz eines einstellbaren Impedanzelements (11) zur Steuerung der Stromversorgung eines Elektromotors (M), insbesondere für ein Kraftfahrzeug, mit Messmitteln (13a) zur Messung der Stromstärke des durch das besagte einstellbare Impedanzelement (11) hindurchfließenden Stroms und mit einer Strombegrenzungseinheit ($U_c$, 13), die mit den besagten Messmitteln (13a) verbunden ist und die das besagte einstellbare Impedanzelement (11) so steuert, dass die besagte Stromstärke verringert wird, wenn sie größer als ein gegebener Schwellenwert ist, **dadurch gekennzeichnet, dass** die besagte Strombegrenzungseinheit Mittel umfasst, um den Stromstärkenschwellenwert mit der Spannung zwischen den Enden des Motors (M) ansteigend zu verändern.

6. Vorrichtung nach Anspruch 5, **dadurch gekennzeichnet, dass** die Messmittel einen Nebenschlusswiderstand (13a) umfassen, der mit dem Motor (M) und dem einstellbaren Impedanzelement (11) in Reihe geschaltet ist, wobei die Spannung zwischen den Enden des besagten Widerstands (13a) an einem Eingang der Strombegrenzungseinheit (13) eingespeist wird.

7. Vorrichtung nach einem der Ansprüche 5 und 6, **dadurch gekennzeichnet, dass** die zulässige Schwellenstromstärke für eine Nullspannung zwischen den Enden des Motors (M) ausreichend ist, um das Anlassen dieses Motors zu ermöglichen.

8. Vorrichtung nach einem der Ansprüche 5 bis 7, **dadurch gekennzeichnet, dass** die Strombegrenzungseinheit (13) eine Analogeinheit ist, wobei die Schwellenstromstärke eine lineare Funktion der Klemmenspannung des Motors (M) ist.

9. Vorrichtung nach einem der Ansprüche 5 bis 8, **dadurch gekennzeichnet, dass** die Strombegrenzungseinheit (13) eine Digitalverarbeitungseinheit ist.

10. Vorrichtung nach einem der Ansprüche 5 bis 9, **dadurch gekennzeichnet, dass** das einstellbare Impedanzelement (11) ein MOSFET-Transistor ist.

**Claims**

1. A method of protecting an adjustable impedance element (11) controlling the power supply of an electric motor (M), in particular in a motor vehicle, in which the control of said adjustable impedance element (11) is modified when the current passing through it exceeds a given threshold, the method being **characterized in that** the current threshold is an increasing function of the voltage ($U_M$) across the terminals of the motor (M).

2. A method according to claim 1, **characterized in that** the current threshold authorized for zero voltage across the terminals of the motor (M) is sufficient to enable it to start.

3. A method according to any preceding claim, **characterized in that** the threshold current is a linear function of the voltage across the terminals of the motor (M).

4. A method according to any preceding claim, **characterized in that** the adjustable impedance element (11) is a MOSFET type transistor.

5. Apparatus for protecting an adjustable impedance element (11) controlling the power supply to an electric motor (M), in particular in a motor vehicle, the apparatus comprising means (13a) for measuring the current passing through said adjustable impedance element (11) and a current limiter unit (U$_c$, 13) connected to said measurement means (13) and controlling said adjustable impedance element (11) in such a manner as to reduce said current [when it] exceeds a given threshold, **characterized in that** said current limiter unit includes means for varying the current threshold with increasing voltage across the terminals of the motor (M).

6. Apparatus according to claim 5, **characterized in that** the measurement means include a current-sensing resistor (13a) connected in series with the motor (M) and the adjustable impedance element (11), the voltage across the terminals of said resistor (13a) being applied to an input of the current limiter unit (13).

7. Apparatus according to claim 5 or 6, **characterized in that** the current threshold authorized for zero voltage across the terminals of the motor (M) is sufficient to enable the motor to start.

8. A device according to any one of claims 5 to 7, **characterized in that** the current limiter unit (13) is an analog unit, the threshold current being a linear function of the voltage across the terminals of the motor (M).

9. Apparatus according to any one of claims 5 to 8, **characterized in that** the current limiter unit (13) is a digital processor unit.

10. Apparatus according to any one of claims 5 to 9, **characterized in that** the adjustable impedance element (11) is a MOSFET type transistor.

FIG.1

FIG.2

FIG.3

FIG.4